# EUROPEAN PATENT SPECIFICATION

(11) **EP 1 205 792 B1**
(45) Date of publication and mention of the grant of the patent: **27.08.2003**
(21) Application number: 00203935.2
(22) Date of filing: 08.11.2000
(51) Int. Cl.: G03B 33/16, G03B 33/14, G03F 3/10, G03F 5/08, H04N 9/12

(54) **Apparatus and method for recording or reconstructing colour image information by means of a black & white film**
Vorrichtung und Verfahren zum Aufzeichnen bzw. Wiedergeben von farbigen Bildinformation mittels eines Schwarz-Weiss Films
Dispositif et procédé pour enregistrer ou réconstruire une information composée d'une image en couleur au moyen d'un film noir et blanc

(43) Date of publication of application: 15.05.2002
(73) Proprietor: Fuji Photo Film B.V., 5047 TK Tilburg (NL)
(72) Inventor: Toda, Yuzo, 5051 KZ Goirle (NL); Palmius, Kjell, 5056 CD Berkel-Enschot (NL)
(74) Representative: Prins, Adrianus Willem

(56) References cited:
- US-A- 3 715 461
- US-A- 3 820 992
- US-A- 3 824 609
- US-A- 4 060 643
- R. W. G. HUNT: "The Reproduction of Colour" 1995 , FOUNTAIN PRESS ENGLAND , KINGSTON-UPON-THAMES XP002167664 086343 * page 45 - page 53 *

## Description

The invention relates to an apparatus for recording on a black & white photographic film information representing a pattern of coloured light, wherein the apparatus comprises at least a housing with an opening through which, during use, the coloured light enters the housing, wherein the housing comprises within the housing a substantially plane-like position which is, during use, occupied by the black & white film, wherein the apparatus further comprises a mask positioned in a light path extending from the opening to the plane-like position, wherein the mask comprises at least one set of colourfilters, wherein each set comprises at least two colourfilters having different predetermined wavelength transmission characteristics

The invention also relates to a method for recording on a black & white photographic film information representing a pattern of coloured light.

The invention further relates to an apparatus for reconstructing from a black & white image information representing a pattern of coloured light.

The invention also relates to a method for reconstructing from a black & white image information representing a pattern of coloured light.

An apparatus of the type mentioned in the preamble of claim 1 is known from US 3, 715,461. In this document the use of a mask is disclosed for recording onto a black & white photographic film information representing a pattern of coloured light.

The background of this technique is related to the differences in costs between use of colour photography and black & white photography.

In conventional colour photography, the photographic film contains several types of silverhalide emulsion layers wherein each layer is sensitive to exposure of either blue, green or red light. Accordingly, several types of expensive components like scavenging agents, couplers and sensitising and dyes are needed during manufacturing of such a film. The manufacturing and developing of such a colour photographic film involves thus a complicated method. In relation to this, not only the film itself is expensive, but also the processing turns out to be a costly event. Since the black & white photographic film does not require any coupler nor any scavenging agent but has an additional advantage in that it only contains one silver halide emulsion layer, the manufacturing and processing of this film is relatively simple and inexpensive in comparison to the manufacturing of the conventional colour film. In conventional black & white photography, a photographic film, containing a silver halide emulsion coated on a transparent film support, is exposed to an image, for example, a pattern of coloured light. This produces a latent image (pattern) within the emulsion layer. The film is then photographically processed to transform the latent image into a silver image which is a negative image of the object photographed. The resulting processed photographic film element, the negative image, is then placed between a uniformly exposing light source and a black & white photosensitive paper. A black & white photographic print is then obtained. The original pattern of coloured light is, in this case, reduced to a pattern of grey intensities.

It has been a challenge to develop a technique for recording on a black & white film information representing a pattern of coloured light, in such a way, that the technique allows for reconstructing the information representing a pattern of coloured light from a black & white image. To this end, the method described in US 3,715,461 uses the earlier mentioned mask which is placed atop the black & white film such that the mask masks the photosensitive side of the film. The mask comprises a plurality of sets of three colour filters. In each set, a first colour filter only transmits a blue wavelength range, a second colour filter only a green wavelength range, and a third colour filter only a red wavelength range. In use, the pattern of coloured light is projected onto the mask. The light exiting the mask is composed of spatially separated red light beams, green light beams and blue light beams. As the colour filters are, according to US 3,715,461, line-shaped, exposure of the black & white film by the light exiting the mask as described, finally results in a pattern of grey-lines on the black & white film. The grey-intensity may vary along the longitudinal direction of each line as a result of varying colour intensities in the original pattern of coloured light. Due to the differently coloured light beams exiting the colour filters, the grey-intensity may also vary from line to line. As the intensity transmittance of colourfilters only transmitting the blue wavelength range, is more then for filters only transmitting the green wavelength range, which is, on its turn, more then the intensity transmittance for the colourfilters which only transmit the red wavelength range, each specific colourfilter has, according to US 3,715,461, a different width of respectively 25, 35 and 40% of the total width of each set wherein each set comprises a blue, a green and a red filter. The differences in width is intended to compensate for the differences in transmitted intensity. The differences in width for each filter is also mentioned to be used for detecting the location of each colourfilter, as the width corresponds to the transmitted wavelength range. The width is in this sense an identification mark of the wavelength transmission chracteristics of the colourfilter. By scanning the film point by point and determining the (relative) width of the lines ( a process which is not clearly disclosed in US 3,715,461), the information comprising a pattern of coloured light, is reproducable from the black & white film after conversion of a measured grey intensity at a scannned position into the predetermined colourrange which corresponds to the width of the scanned grey line. Further electronic treatment and the use of a colour laser or a TV enables production of the original pattern of coloured light.

A disadvantage of the mask comprising colourfilters with different widths as disclosed in US 3,715,461 is that the contribution of the red beam to the recorded pattern is spatially high in comparison to the contribution of the green beam. The contribution of the green beam to the recorded pattern is, on its turn, spatially high in comparison to the contribution of the blue beam. In other words the intended compensation for the differences in intensity transmittance leads to unequal spatial contributions to the recording of the pattern of coloured light, for which no simple correction is proposed. The unequal spatial contributions of the three differently coloured beams result in a systematic error in the information representing the pattern of coloured light as recorded onto the black &white film. Consequently, the reconstructed information representing a pattern of coloured light is similarly suffering from such a systematic error.

Another disadvantage of this system is that as the difference in width of the lines is used for recognising the colour of the filter, it is not possible to improve the resolution by minimising the width of each filter. The resolution is determined by the minimum distance between two centres of area's which can contain different information in terms of colourwavelength range and intensity. The resolution in this context is defined such that the resolution increases as this minimum distance decreases. In the mask known from US 3,715,461, the width of two colourfilters always need to be larger than the minimum width possible for a colourfilter.

The invention aims to provide an improved apparatus for recording on a black & white film information representing a pattern of coloured light.

To this end , the apparatus according to the invention is characterised in that the mask further comprises separate from and in addition to the at least one set of colourfilters at least one identification mark which is projectable onto the black & white film, wherein the position of the at least one identification mark corresponds according to a predetermined relationship with the position of at least one set and/or with the position of at least one colourfilter. This has the advantage that the colour filters are, apart from filtering light, not necessarily also used as identification mark with the result that an alteration of the at least one identification mark not necessarily affects the colourfilters and that an alteration of the colourfilters not necessarily affects the at least one identification mark.

According to a preferred embodiment the apparatus according to the invention is characterised in that the at least one set is rectangular. This has the advantage that the design of the mask, the scanning of the black & white image for reconstructing the information and the reconstruction itself can be done according to simple patterns.

According to a more preferred embodiment the apparatus according to the invention is characterised in that the at least two colourfilters are line-shaped running across the mask in a direction parallel to the longitudinal direction of the at least one set. This allows for further simplifying the design of the mask, the scanning of the black & white image for reconstructing the information and the reconstruction itself.

A much preferred embodiment according to the invention is characterised in that each colourfilter has an equal width extending perpendicular to the longitudinal direction of the colourfilter. This has the advantage that the differently coloured light beams exiting the mask spatially contribute equally to the information representing the pattern of coloured light. The recorded information is not suffering from a systematic error as a result of spatially unequal distributions of differently coloured beams.

A very much preferred embodiment of the apparatus according to the invention is characterised in that the mask comprises a plurality of sets of colourfilters. This offers the advantage that the pattern to be recorded can be recorded with an improved resolution in comparison to recording with a mask comprising only one set of colourfilters. This embodiment is especially suitable for recording information representing a complex pattern of coloured light. With a minimum width for the colourfilters it is furthermore possible to achieve excellent resolution.

A method for recording on a black & white photographic film information representing a pattern of coloured light, is characterised in that an apparatus according to any of the claims 1-20 is employed, wherein the method comprises the following steps a) the black & white film is positioned in the housing such that the black & white film occupies the plane-like position; b) the pattern of coloured light enters an opening in the housing and is projected onto the mask; c) the light is transmitted through the colour filters; d) the light as transmitted through the colourfilters is projected onto a black & white film and e) the at least one identification mark is exposed to light such that the identification mark is projected onto the black & white film.

An apparatus for reconstructing from a black & white image information representing a pattern of coloured light as recorded on a black & white film by employment of an apparatus according to any of the claims 1-20, wherein the apparatus for reconstructing comprises a scanner for scanning the black & white image on the film or on a processed version of the film, wherein the scanner is arranged to carry out grey-intensity measurements as a function of scan-positions, wherein the apparatus further comprises means for recognising as a function of a scan-position the at least one identification mark which is present on the black & white image, wherein the apparatus is further arranged to convert, based on the scan-position of the at least one identification mark, the grey-intensities as measured as a function of the scan-positions into a predetermined colourrange intensity.

A method for reconstructing from a black & white image as recorded on a black & white film by applying an apparatus according to any of the claims 1-20, information representing a pattern of coloured light, wherein the method is carried out by employment of an apparatus according to any of the claims 23-27, wherein the method comprises the following steps: a) scanning the black & white image and measuring as a function of scanposition grey-intensities; b) recognising as a function of scan-positions the at least one identification mark which is present on the black & white image; c) converting, based on the scan-position of the at least one identification mark, the grey-intensity as measured as a function of the scanposition into a predetermined colourrange intensity.

### Brief descriptions of the drawings:

The above mentioned aspects and other embodiments of the invention are described in detail in conjunction with the accompanying drawing. Herein shows:
Figure 1 a schematic diagram of an apparatus according to the invention for recording on a black & white photographic film information comprising a pattern of coloured light;
Figure 2 a schematic diagram of a mask according to the invention and a black & white film;
Figure 3 a schematic cross section of a first embodiment of a mask according to the invention placed atop a photographic black & white film;
Figure 4 a schematic cross section of a second embodiment of a mask according to the invention placed atop a photographic black & white film;
Figure 5 a schematic cross section of a third embodiment of a mask according to the invention placed atop a black & white photographic film
Figure 6 a schematic cross section of a fourth embodiment of a mask according to the invention placed atop a black & white photographic film;
Figure 7 a top view of an embodiment of a mask according to the invention;
Figure 8 a top view of an alternative embodiment of a mask according to the invention;
Figure 9 a schematic diagram representing a method according to the invention for reconstructing from a black & white image information comprising a pattern of coloured light.

### Detailed description of the invention.

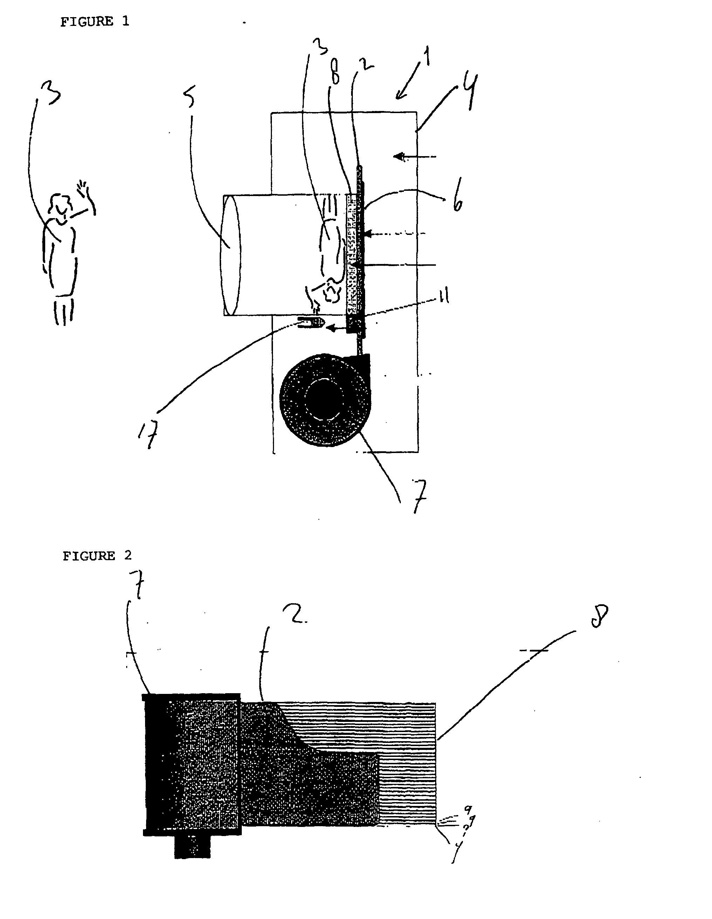

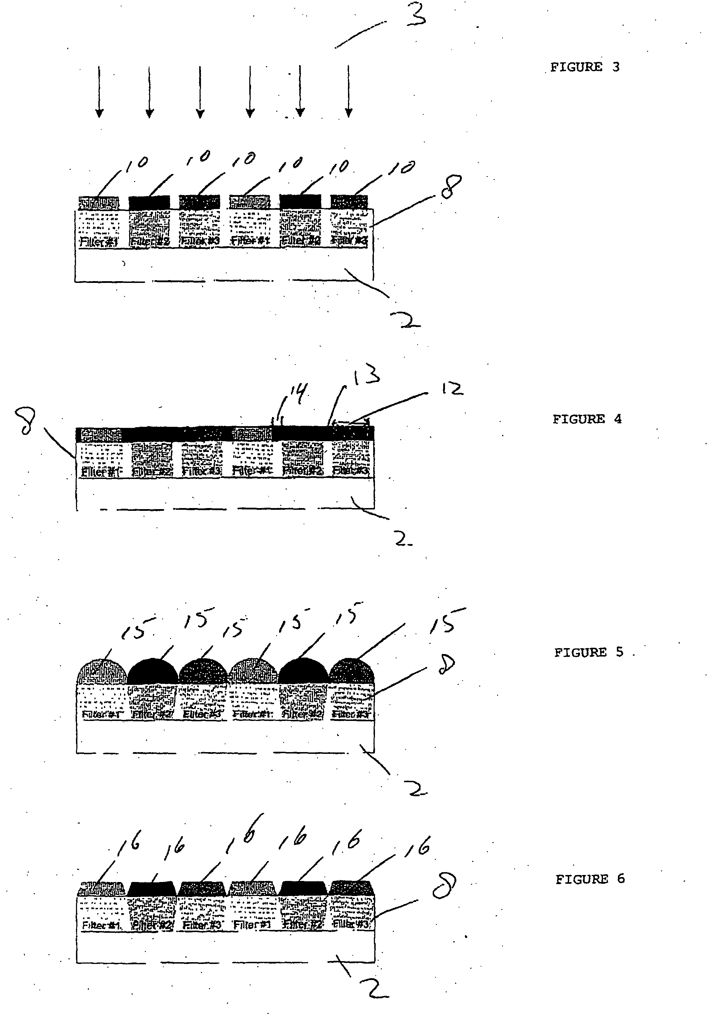

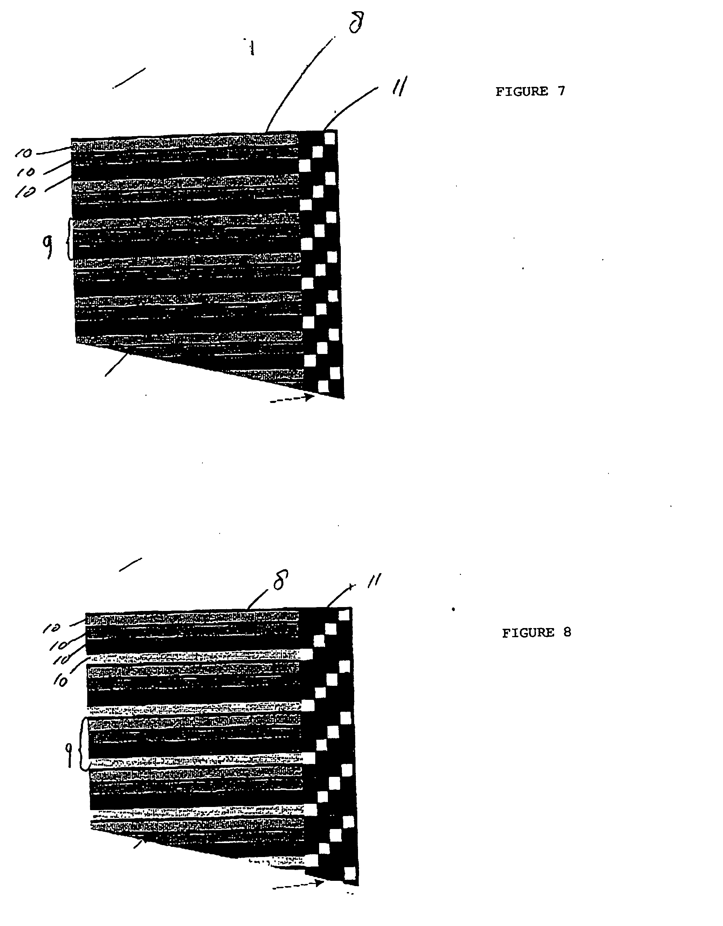

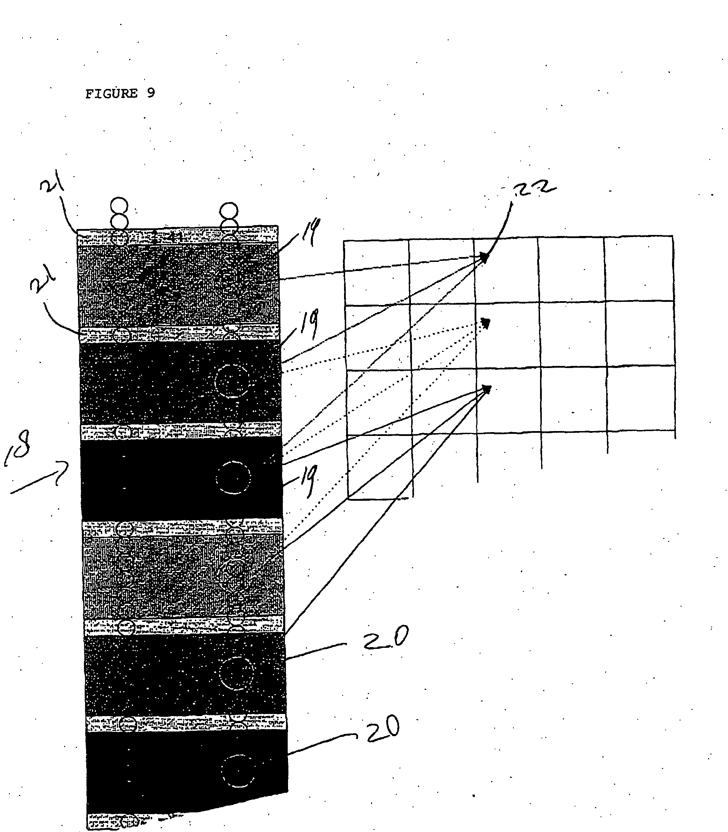

Figure 1 shows an apparatus 1 for recording on a black & white photographic film 2 information comprising a pattern of coloured light 3. The apparatus comprises a housing 4 with an opening 5 through which, during use, the coloured light 3 enters the housing 4. The housing 4 comprises within the housing 4 a substantially plane-like position 6 which is, during use, occupied by the black & white film 2. The black & white film 2 is usually stored in a film cassette 7. The apparatus 1 comprises a mask 8 positioned in a light path extending from the opening 5 to the plane-like position 6. The mask 8 as shown in figure 2, comprises a plurality of substantially rectangular sets 9 of colourfilters 10 extending across the mask 8. It is, of course, equally possible that the mask comprises only one set of colourfilters. Each set 9 comprises a three line-shaped colourfilters 10, each having mutually different wavelength transmission characteristics, (see figure 3). Preferably a first colourfilter out of the three line-shaped colourfilters has red wavelength transmission characteristics, a second one has green wavelength transmission characteristics and a third one has blue wavelength transmission characteristics. The colourfilters 10 run across the mask 8 in a direction parallel to the longitudinal directions of the rectangular sets 9. The mask 8 further comprises, in addition to and separate from the line-shaped colourfilters 10, a plurality of identification marks 11 which are projectable onto the black & white film 2 as shown in figure 7. The identification marks 11 correspond according to a predetermined relationship with the subsequent positions of the sets 9 and/or the colourfilters 10. Although in the example as drawn many identification marks 11 are shown, it is also possible to have only one mark 11. In the case of one mark 11 the position of the mark 11 indicates the predetermined position of each set 9. If the sets are identical, then also the position of each colourfilter 10 is fixed. In the cross-sectional view of the mask 8 (in figure 3) each colourfilter 10 has an equal width 12 extending perpendicular to the longitudinal direction of the colourfilter 10. The width 12 of each colourfilter 10 is preferably less than 50 micrometer. Even better would be a width 12 of each colourfilter equal to less than 20 micrometer. Ideally, the width 12 of each colourfilter 10 is less than 5 micrometer. The width 12 corresponds, in this case, roughly with at least two times the size of a silverhalide grain. A preferred embodiment of the mask 8 is shown in figure 4 wherein the mask comprises between each pair of colourfilters 10 at least one separating line 13. Due to the separating lines 13, mixing of light transmitted by neighbouring colourfilters 10 is prevented. For reasons elsewhere explained in this description, the separating lines 13 may also be called tracking lines. The width 14 of the separating line 13 equals about 15 to 25 percent of the width 12 of a colourfilter 10. The cross-sectional shape of the line shaped colourfilter 10, is in a preferred embodiment in figure 5 such that the incoming light traverses a convexly shaped lens 15 with the result that light exiting the mask converts to a smaller area on the black & white film 2. This also prevents mixing of light on the black & white film 2 and may, due to the converting beams have a similar effect on the black & white film 2 as the presence of the separating lines 13 on the mask 8 have. A variation on the convex shape is shown in figure 6 where the cross sectional shape of the line-shaped colourfilters 10 correspond to a trapezium 16. Figure 7 shows a top view of a mask 8 according to the invention. Mask 8 comprises three different colourfilters 10. Through each colourfilter 10 either a red wavelength range is transmittable, a green wavelength range or a blue wavelength range is transmittable. An alternative mask 8 comprises four colourfilters 10, each having mutually different wavelength transmission characteristics, as shown in figure 8. It will be clear from the figures 1-6, that the method for recording on a black & white photographic film 2 information comprising a pattern of coloured light 3 wherein a apparatus 1 is employed, comprises the following steps: a) the black & white film 2 is positioned in the housing 4 such that the black & white film 2 occupies the plane-like position 6; b) the pattern of coloured light 3 enters an opening 5 in the housing 4 and is projected onto the mask 8; c) the light is transmitted by the colour filters 10; d) the light as transmitted through the colourfilters 10 is projected onto a black & white film 2 and e) the at least one identification mark 11 is exposed to light such that the identification mark 11 is projected onto the black & white film 2.
1. For step d), light entering the housing 4 can be used, but preferably the apparatus 1 for recording on a black & white photographic film 2 information representing a pattern of coloured light 3, comprises, for this purpose, a Light Emitting Device (LED) 17 as shown in figure 1. A result of a method for recording black & white photographic film 2 information representing a pattern of coloured light 3, is shown in figure 9. The black & white film 18 carrying information representing a pattern of coloured light, contains various lines 19 with different grey-intensities. Equally coloured lines 21, usually either fully black & white due to respectively full exposure or no exposure to light, are due to the separating lines 13 on the mask 8. With an apparatus (not shown) for reconstructing information representing a pattern of coloured light as recorded on a black & white film 2, wherein the apparatus comprises a scanner for scanning the black & white image 18, grey intensity measurements are carried out as a function of scanpositions 20. The equally coloured lines 21 may be used as tracking or guidance lines during scanning to ensure that the difference between two adjacent grey lines 19 is more accurately established and/or verified. During scanning the apparatus for reconstructing information representing a pattern of coloured light from a black &white image may furthermore verify and/or more accurately establishes a scanposition 20 as a function of the measured grey-intensity using a difference between the intensity of the equally coloured lines 21 and other grey-intensities on the black & white image 18, wherein the equally coloured lines 21 are due to the presence of separating lines 13 on the mask 8. Suitable scanners (not shown) are well-known and widely available. The apparatus for reconstructing information representing a pattern of coloured light as recorded on a black & white film 2 further comprises means for recognising as a function of the scan-position identification marks 11which are present on the black & white image 18. These identification marks are not shown on the black & white image 18 in figure 9. As described above, the identification marks correspond to positions with a predetermined colourrange of the pattern of coloured light. Means for recognising are widely available and most likely comprise a memory in which the predetermined relationships with respect to positions and colourranges are stored. These means for recognising will further comprise a microprocessor in which signals from the scanner and the memory are combined to generate a signal for conversion of the measured grey-intensities into a predetermined colourrange intensity. The apparatus for reconstructing information representing a pattern of coloured light 3 as recorded on a black & white film 2 is further arranged to convert, based on the scan-position of the at least one identification mark, the grey intensity as measured as a function of the scan-positions 20 into a predetermined colourrange intensity. By taking a set of grey intensity measurements 22 as obtained from scan-positions 20 within an area of the black & white image, and conversion of each grey intensity into a predetermined colouring intensity, a colour of the area within the pattern of coloured light is reconstructed by the apparatus. By subsequently carrying out this process the apparatus is capable of reconstructing the information comprising a pattern of coloured light from the black & white image 18. It is clear that with a reduction of the width 12 of the lines 19 the resolution of the pattern of coloured light will improve. Preferably, the scanner has a scanner resolution such that 50 micrometer is recordable by these two pixels. More in particular the scanner has a scanner resolution such that 20 micrometer is recordable by these two pixels. Ideally, the scanner has a scanner resolution such that 5 micrometer is recordable by these two pixels. This means that one pixel will in any case completely fit within one line with a width equal to 5 micrometer. The apparatus for reconstructing information representing a pattern of coloured light as recorded on a black & white film 2 further comprises means to digitally store and display the information comprising the pattern of coloured light. This allows for further finetuning and manipulation of the image. A method for reconstructing from a black & white image 18 as recorded on a black & white film 2 information representing a pattern of coloured light, wherein the method is carried out by employment of the hereto described apparatus comprises the following steps: a) scanning the black & white image 18 and measuring as a function of scan-position grey-intensities; b) recognising as a function of scan-positions 20 the at least one identification mark 11 which is present on the black & white image 18; c) converting, based on the scan-position of the at least one identification mark 11, the grey-intensity as measured as a function of the scanposition into a predetermined colourrange intensity. Obviously, the colour reconstruction is more accurate if more different lines contribute to the reconstruction. In this respect it is recommended to use a mask comprising a plurality of sets of colourfilters, wherein each set comprises three or four colourfilters 10 having each mutually different wavelength transmission characteristics. It turns out that the reconstruction as described corresponds to a very large extent to a reconstruction carried out by human beings after recording with a naked eye, if the different wavelength characteristics of the colourfilters used in the recording apparatus at least partly overlap. It is furthermore in this respect advantegeous if the method for reconstructing from a black & white image 18, information representing a pattern of coloured light 3 comprises means for digitally storing and/or displaying and/or manipulating the converted information representing a pattern of coloured light. Most preferably, in step c) the predetermined colourrange intensity is adjusted as a function of at least two predetermined colourranges. In this case, the at least two predetermined colourranges may correspond, apart from the colourrange under consideration, to the colourranges into which the grey-lines adjacent to the relevant grey-line are converted. In step c) the intensity of the colourrange intensity may further be adjusted as a function of the measured grey-intensities of at least two predetermined scanpositions. In this case, the at least two predetermined grey-intensities may for instance correspond, apart from the intensity under consideration, to grey-lines adjacent to the relevant grey-line. In this process the information in terms of intensity and/or colourrange related to the closest relevant scan-positions may be used, but in addition to this, also the information related to the second closest scan-positions can be taken into account. The earlier mentioned microprocessor will be arranged to convert according to a pre-installed conversion program the intensities. The mask 8 may contain one or more sets 9 of colourfilters 10. In the case of one set 9, the colourfilters 10 may be spaced by a predetermined mutual distance. This distance may for instance refer to the shortest distance between the centres of the colourfilters 10 or to the distance between the colourfilters. Also the separating line 13 may correspond to this distance. In the case of more sets, the sets can be mutually different or all identical. Also the sets 9 may be spaced by a predetermined mutual distance. If the sets 9 are all identical, it may even be that all the colourfilters 10 are spaced by a predetermined mutual distance. Obviously this latter situation results in good resolution of the information representing a pattern of coloured light. Furthermore little memory is needed in the apparatus for reconstructing from a black & white image. To compensate for differences in intensity as transmitted by the mutually different colourfilters 10, the length of the path which the light has to traverse through the filters may be different, although such a compensation is also easily done by the digital means for manipulation of the converted information representing the pattern of coloured light.

It will be understood that the invention is by no means limited to the above described embodiments and examples. Various lenses can be inserted in the light path between the opening 5 in the housing 4 and/or between the mask 8 and the black & white film 2, although it is preferred to minimise the distance between the mask 8 and the black & white film 2. The width of the colourfilters 10 can be as small as possible but is ideally at least twice as large as the size of the silver halide grains in the black & white film. The final resolution of the pattern of coloured light as recorded from a black & white image 18 is determined by the scanresolution and the width of the lines. Reproduction of a colour by combining the intensities of three predetermined colours can be done according to various algorithms. The particular features or a particular mask can be given as input for the apparatus for reconstructing information comprising a pattern of coloured light from a black & white image 18 such that only recognition of one identification mark 11 is sufficient for converting measured grey intensities into predetermined colourrange intensities. Such upgrading schemes and modifications are all understood to fall within the framework of the invention as claimed.

## Claims

1. Apparatus (1) for recording on a black & white photographic film (2) information representing a pattern of coloured light (3), wherein the apparatus (1) comprises at least a housing (4) with an opening (5) through which, during use, the coloured light (3) enters the housing (4), wherein the housing (4) comprises within the housing a substantially plane-like position (6) which is, during use, occupied by the black & white film (2), wherein the apparatus further comprises a mask (8) positioned in the light path extending from the opening to the plane-like position (6), wherein the mask (8) comprises at least one set (9) of colourfilters (10), wherein each set (9) comprises at least two colourfilters (10) having different predetermined wavelength transmission characteristics, **characterised in that**, the mask (8) further comprises separate from and in addition to the at least one set of colourfilters at least one identification mark (11) which is projectable onto the black & white film (2), wherein the position of the at least one identification mark corresponds according to a predetermined relationship with the position of at least one set and/or with the position of at least one of the colourfilters.

2. Apparatus according to claim 1, **characterised in that** the at least one set is rectangular.

3. Apparatus according to claim 2, **characterised in that** the at least two colourfilters are line-shaped running across the mask in a direction parallel to the longitudinal direction of the at least one set.

4. Apparatus according to claim 2 or 3, **characterised in that** each colourfilter has an equal width extending perpendicular to the longitudinal direction of the colourfilter.

5. Apparatus according to claim 4, **characterised in that** the width of each colourfilter is less than 50 micrometer.

6. Apparatus according to claim 5, **characterised in that** the width of each colourfilter is less than 20 micrometer.

7. Apparatus according to claim 6, **characterised in that** the width of each colourfilter is less than 5 micrometer.

8. Apparatus according to any of the previous claims, **characterised in that** the at least two colourfilters are spaced by a predetermined mutual distance.

9. Apparatus according to any of the previous claims, **characterised in that**, the mask comprises between each pair of colourfilters at least one separating line.

10. Apparatus according to any of the claims 8 and 9, **characterised in that**, the separating line (13) has a predetermined width whereby the distance between the the at least two colourfilters is predetermined.

11. Apparatus according to any of the previous claims, **characterised in that**, the at least one set contains at least three colourfilters having mutually different wavelength transmission characteristics.

12. Apparatus according to claim 11, **characterised in that**, a first colourfilter of the at least one set comprises red wavelength transmission characteristics, a second colourfilter of the at least one set comprises green wavelength transmission chracteristics and a third colourfilter of the at least one set comprises blue wavelength transmission characteristics.

13. Apparatus according to any of the previous claims, **characterised in that**, the at least one set contains at least four colourfilters having mutually different wavelength transmission characteristics.

14. Apparatus according to any of the previous claims, **characterised in that** at least two of the colourfilters of the at least one set have different wavelength transmission characteristics which at least partly overlap.

15. Apparatus according to any of the previous claims, **characterised in that**, at least one of the colour filters is shaped such that the light exiting the at least one colour filter converges between the at least one colour filter and the black & white film.

16. Apparatus according to any of the previous claims, **characterised in that** the apparatus comprises a Light Emitting Device (17) so as to project the at least one identification mark onto the black & white film.

17. Apparatus according to any of the previous claims, **characterised in that** the mask comprises a plurality of sets of colourfilters.

18. Apparatus according to claim 17, **characterised in that** the sets are. identical

19. Apparatus according to any of the claims 17-18, **characterised in that** the sets are spaced by a predetermined mutual distance.

20. Apparatus according to any of the claims 8 and 17-19, **characterised in that** all colourfilters are spaced by a predetermined mutual distance.

21. Mask according to any of the previous claims.

22. Method for recording on a black & white photographic film information representing a pattern of coloured light, wherein an apparatus according to any of the claims 1-20 is employed, wherein the method comprises the following steps a) the black & white film is positioned in the housing such that the black & white film occupies the plane-like position; b) the pattern of coloured light enters an opening in the housing and is projected onto the mask; c) the light is transmitted through the colour filters; d) the light as transmitted through the colourfilters is projected onto a black & white film and e) the at least one identification mark is exposed to light such that the identification mark is projected onto the black & white film.

23. Apparatus for reconstructing from a black & white image information representing a pattern of coloured light as recorded on a black & white film by employment of an apparatus according to any of the claims 1-20, wherein the apparatus for reconstructing comprises a scanner for scanning the black & white image on the film or on a processed version of the film, wherein the scanner is arranged to carry out grey-intensity measurements as a function of scan-positions, wherein the apparatus further comprises means for recognising as a function of a scan-position the at least one identification mark which is present on the black & white image, wherein the apparatus is further arranged to convert, based on the scan-position of the at least one identification mark, the grey-intensities as measured as a function of the scan-positions into a predetermined colourrange intensity.

24. Apparatus according to claim 23, **characterised in that** the apparatus further comprises means to digitally store and/or display and/or manipulate the converted information representing the pattern of coloured light.

25. Apparatus according to claim 23 or 24, **characterised in that** the scanner has a scanresolution such that 50 micrometer is recordable by at least two pixels.

26. Apparatus according to claim 25, **characterised in that** the scanner has a scanresolution such that 20 micrometer is recordable by at least two pixels.

27. Apparatus according to claim 26, **characterised in that** the scanner has a scanresolution such that 5 micrometer is recordable by at least two pixels.

28. Method for reconstructing from a black & white image as recorded on a black & white film by applying an apparatus according to any of the claims 1-20, information representing a pattern of coloured light, wherein the method is carried out by employment of an apparatus according to any of the claims 23-27, wherein the method comprises the following steps: a) scanning the black & white image and measuring as a function of scanposition grey-intensities; b) recognising as a function of scan-positions the at least one identification mark which is present on the black & white image; c) converting, based on the scan-position of the at least one identification mark, the grey-intensity as measured as a function of the scanposition into a predetermined colourrange intensity.

29. Method according to claim 9 and 28, **characterised in that** in step a) the scanner verifies and/or more accurately establishes a scanposition as a function of the measured grey-intensities using a difference between the intensity of at least one equally coloured line and other grey-intensities on the black & white image, wherein the at least one equally coloured line is present due to the presence of the at least one separating line on the mask.

30. Method according to any of the claims 28 or 29, **characterised in that**, the method also comprises digitally storing and/or displaying and/or manipulating the converted information representing a pattern of coloured light.

31. Method according to any of the claims 28-30, **characterised in that** in step c) the predetermined colourrange intensity is adjusted as a function of at least two predetermined colourranges.

32. Method according to any of the claims 28-31, **characterised in that** in step c) the intensity of the colourrange intensity is further adjusted as a function of the measured grey-intensities of at least two predetermined scanpositions.

## Patentansprüche

1. Vorrichtung (1) zum Aufzeichnen von Informationen, die ein Muster aus farbigem Licht (3) darstellen, auf einem Schwarz-Weiß-Fotofilm (2), wobei die Vorrichtung (1) wenigstens ein Gehäuse (4) mit einer Öffnung (5) umfasst, durch die während des Einsatzes das farbige Licht (3) in das Gehäuse (4) eintritt, wobei das Gehäuse (4) im Gehäuse eine im Wesentlichen ebenenähnliche Position (6) aufweist, die während des Einsatzes von einem Schwarz-Weiß-Film (2) eingenommen wird, wobei die Vorrichtung des Weiteren eine Maske (8) umfasst, die in **dem** Lichtpfad positioniert ist, der sich von der Öffnung zur ebenenähnlichen Position (6) erstreckt, wobei die Maske (8) wenigstens einen Satz (9) von Farbfiltern (10) umfasst, wobei jeder Satz (9) wenigstens zwei Farbfilter (10) umfasst, die unterschiedliche, vorgegebene Wellenlängen-Übertragungsmerkmale aufweisen, **dadurch gekennzeichnet, dass** die Maske (8) des Weiteren wenigstens eine, von dem wenigstens einen Satz von Farbfiltern getrennte und zusätzliche Markierung (11) aufweist, die auf den Schwarz-Weiß-Film (2) projizierbar ist, wobei die Position von der wenigstens einen Markierung gemäß einer vorgegebenen Beziehung der Position von wenigstens einem Satz und/oder der Position von wenigstens einem der Farbfilter entspricht.

2. Vorrichtung nach Anspruch 1, **dadurch gekennzeichnet, dass** der wenigstens eine Satz rechwinklig ist.

3. Vorrichtung nach Anspruch 2, **dadurch gekennzeichnet, dass** die wenigstens zwei Farbfilter linienförmig über die Maske in einer Richtung verlaufen, die parallel zur Längsrichtung von dem wenigstens einen Satz ist.

4. Vorrichtung nach Anspruch 2 oder 3, **dadurch gekennzeichnet, dass** jeder Farbfilter eine gleiche Breite besitzt, die sich senkrecht zu der Längsrichtung des Farbfilters erstreckt.

5. Vorrichtung nach Anspruch 4, **dadurch gekennzeichnet, dass** die Breite jedes Farbfilters weniger als 50 Mikrometer beträgt.

6. Vorrichtung nach Anspruch 5, **dadurch gekennzeichnet, dass** die Breite jedes Farbfilters weniger als 20 Mikrometer beträgt.

7. Vorrichtung nach Anspruch 6, **dadurch gekennzeichnet, dass** die Breite jedes Farbfilters weniger als 5 Mikrometer beträgt.

8. Vorrichtung nach einem der vorhergehenden Ansprüche, **dadurch gekennzeichnet, dass** die wenigstens zwei Farbfilter um eine vorgegebene gegenseitige Entfernung beabstandet sind.

9. Vorrichtung nach einem der vorhergehenden Ansprüche, **dadurch gekennzeichnet, dass** die Maske zwischen jedem Paar von Farbfiltern wenigstens eine Trennlinie aufweist.

10. Vorrichtung nach einem der Ansprüche 8 und 9, **dadurch gekennzeichnet, dass** die Trennlinie (13) eine vorgegebene Breite besitzt, durch welche die Entfernung zwischen den wenigstens zwei Farbfiltern vorgegeben wird.

11. Vorrichtung nach einem der vorhergehenden Ansprüche, **dadurch gekennzeichnet, dass** der wenigstens eine Satz wenigstens drei Farbfilter enthält, die gegenseitig unterschiedliche Wellenlängen-Übertragungsmerkmale aufweisen.

12. Vorrichtung nach Anspruch 11, **dadurch gekennzeichnet, dass** ein erster Farbfilter von dem wenigstens einen Satz Übertragungsmerkmale für rote Wellenlängen, ein zweiter Farbfilter von dem wenigstens einen Satz Übertragungsmerkmale für grüne Wellenlängen und ein dritter Farbfilter von dem wenigstens einen Satz Übertragungsmerkmale für blaue Wellenlängen umfasst.

13. Vorrichtung nach einem der vorhergehenden Ansprüche, **dadurch gekennzeichnet, dass** der wenigstens eine Satz wenigstens vier Farbfilter enthält, die gegenseitig unterschiedliche Wellenlängen-Übertragungsmerkmale aufweisen.

14. Vorrichtung nach einem der vorhergehenden Ansprüche, **dadurch gekennzeichnet, dass** wenigstens zwei der Farbfilter von dem wenigstens einen Satz verschiedene Wellenlängen-Übertragungsmerkmale besitzen, die sich wenigstens teilweise überschneiden.

15. Vorrichtung nach einem der vorhergehenden Ansprüche, **dadurch gekennzeichnet, dass** wenigstens einer der Farbfilter so geformt ist, dass das Licht, das aus dem wenigstens einen Farbfilter austritt, zwischen dem wenigstens einen Farbfilter und dem Schwarz-Weiß-Film konvergiert.

16. Vorrichtung nach einem der vorhergehenden Ansprüche, **dadurch gekennzeichnet, dass** die Vorrichtung eine Leuchteinrichtung (17) umfasst, um die wenigstens eine Markierung auf den Schwarz-Weiß-Film zu projizieren.

17. Vorrichtung nach einem der vorhergehenden Ansprüche, **dadurch gekennzeichnet, dass** die Maske eine Vielzahl von Sätzen von Farbfiltern umfasst.

18. Vorrichtung nach Anspruch 17, **dadurch gekennzeichnet, dass** die Sätze identisch sind.

19. Vorrichtung nach einem der Ansprüche 17 bis 18, **dadurch gekennzeichnet, dass** die Sätze um eine vorgegebene gegenseitige Entfernung beabstandet sind.

20. Vorrichtung nach einem der Ansprüche 8 und 17 bis 19, **dadurch gekennzeichnet, dass** alle Farbfilter um eine vorgegebene gegenseitige Entfernung beabstandet sind.

21. Maske nach einem der vorhergehenden Ansprüche.

22. Verfahren zum Aufzeichnen von Informationen, die ein Muster aus farbigem Licht darstellen, auf einem Schwarz-Weiß-Fotofilm, wobei eine Vorrichtung nach einem der Ansprüche 1 bis 20 verwendet wird, wobei das Verfahren die folgenden Schritte aufweist:
a) der Schwarz-Weiß-Film ist so in dem Gehäuse positioniert, dass der Schwarz-Weiß-Film die ebenenähnliche Position einnimmt;
b) das Muster des farbigen Lichts tritt durch eine Öffnung im Gehäuse ein und wird auf die Maske projiziert;
c) das Licht wird durch die Farbfilter übertragen;
d) das durch die Farbfilter übertragene Licht wird auf einen Schwarz-Weiß-Film projiziert und
e) die wenigstens eine Markierung wird so belichtet, dass die Markierung auf den Schwarz-Weiß-Film projiziert wird.

23. Vorrichtung zum Rekonstruieren von Bildinformationen aus einem Schwarz-Weiß-Film, die ein Muster von farbigem Licht darstellen, wie sie auf einem Schwarz-Weiß-Film unter Einsatz einer Vorrichtung nach einem der Ansprüche 1 bis 20 aufgezeichnet werden, wobei die Vorrichtung zum Rekonstruieren einen Scanner zum Scannen des Schwarz-Weiß-Bildes auf dem Film oder einer bearbeiteten Version des Films umfasst, wobei der Scanner so eingerichtet ist, dass er Graustufenmessungen in Abhängigkeit von den Scanpositionen ausführt, wobei die Vorrichtung des Weiteren Mittel zum Erkennen der wenigstens einen Markierung in Abhängigkeit von einer Scanposition umfasst, die auf dem Schwarz-Weiß-Bild vorhanden ist, wobei die Vorrichtung des Weiteren so ausgelegt ist, dass sie basierend auf der Scanposition der wenigstens einen Markierung die gemessenen Graustufen in Abhängigkeit von den Scanpositionen in eine vorgegebene Farbbereichsintensität konvertiert.

24. Vorrichtung nach Anspruch 23, **dadurch gekennzeichnet, dass** die Vorrichtung des Weiteren Mittel zum digitalen Speichern und/oder Anzeigen und/oder Manipulieren der konvertierten Informationen umfasst, die das Muster aus farbigem Licht darstellen.

25. Vorrichtung nach Anspruch 23 oder 24, **dadurch gekennzeichnet, dass** der Scanner eine solche Scanauflösung besitzt, dass 50 Mikrometer von wenigstens zwei Pixeln aufgezeichnet werden können.

26. Vorrichtung nach Anspruch 25, **dadurch gekennzeichnet, dass** der Scanner eine solche Scanauflösung besitzt, dass 20 Mikrometer von wenigstens zwei Pixeln aufgezeichnet werden können.

27. Vorrichtung nach Anspruch 26, **dadurch gekennzeichnet, dass** der Scanner eine solche Scanauflösung besitzt, dass 5 Mikrometer von wenigstens zwei Pixeln aufgezeichnet werden können.

28. Verfahren zum Rekonstruieren von Bildinformationen aus einem Schwarz-Weiß-Film, die ein Muster von farbigem Licht darstellen, wie sie auf einem Schwarz-Weiß-Film unter Einsatz einer Vorrichtung nach einem der Ansprüche 1 bis 20 aufgezeichnet werden, wobei das Verfahren unter Einsatz einer Vorrichtung nach einem der Ansprüche 23 bis 27 ausgeführt wird, wobei das Verfahren die folgenden Schritte umfasst:
a) Scannen des Schwarz-Weiß-Bildes und Messen der Graustufen in Abhängigkeit von der Scanposition;
b) Erkennen, in Abhängigkeit von Scanpositionen, der wenigstens einen Markierung, die auf dem Schwarz-Weiß-Bild vorhanden ist;
c) auf der Scanposition der wenigstens einen Markierung basierendes Konvertieren der Graustufen, wie sie abhängig von der Scanposition gemessen wurden, in eine vorgegebene Farbbereichsintensität.

29. Verfahren nach Anspruch 9 und 28, **dadurch gekennzeichnet, dass** in Schritt a) der Scanner eine Scanposition in Abhängigkeit von den gemessenen Graustufen überprüft und/oder genauer festlegt, wobei eine Differenz zwischen der Intensität von wenigstens einer gleichfarbigen Linie und anderen Graustufen auf dem Schwarz-Weiß-Bild verwendet wird, wobei die wenigstens eine gleichfarbige Linie dank des Vorhandenseins der wenigstens einen Trennlinie auf der Maske vorhanden ist.

30. Verfahren nach einem der Ansprüche 28 oder 29, **dadurch gekennzeichnet, dass** das Verfahren des Weiteren ein digitales Speichern und/oder Anzeigen und/oder Manipulieren der konvertierten Informationen umfasst, die ein Muster von farbigem Licht darstellen.

31. Verfahren nach einem der Ansprüche 28 bis 30, **dadurch gekennzeichnet, dass** in Schritt c) die vorgegebene Farbbereichsintensität in Abhängigkeit von wenigstens zwei vorgegebenen Farbbereichen angepasst wird.

32. Verfahren nach einem der Ansprüche 28 bis 31, **dadurch gekennzeichnet, dass** in Schritt c) die Intensität der Farbbereichsintensität des Weiteren in Abhängigkeit von den gemessenen Graustufen von wenigstens zwei vorgegebenen Scanpositionen angepasst wird.

## Revendications

1. Appareil (1) d'enregistrement sur un film photographique noir et blanc (2) une scène en couleur (3), dans lequel ledit appareil (1) comprend au moins une chambre (4) avec une ouverture (5) à travers laquelle, lors de l'utilisation, la lumière colorée pénètre dans la chambre (4), dans lequel la chambre (4) comporte en son intérieur un emplacement (6) de forme sensiblement plane qui est, lors de l'utilisation, occupé par le film noir et blanc (2), dans lequel l'appareil comporte en outre un masque (8) placé sur le trajet optique allant de l'ouverture (5) jusqu'à l'emplacement quasi plan (6), dans lequel le masque (8) comprend au moins un ensemble (9) de filtres de couleur (10), dans lequel chaque ensemble (9) comporte au moins deux filtres de couleur (10) présentant des caractéristiques prédéterminées différentes de transmission de longueurs d'ondes, **caractérisé en ce que** le masque (8) comporte, séparément dudit - et adjoint audit au moins un jeu de filtres de couleur, au moins une marque d'identification (11) susceptible d'être projetée sur le film noir et blanc (2), dans lequel la position de ladite au moins une marque d'identification correspond suivant une relation prédéterminée avec la position d'au moins un jeu de filtres et/ou avec la position d'au moins un des filtres de couleur.

2. Appareil selon la revendication 1, **caractérisé en ce que** ledit au moins un ensemble de filtres est de forme rectangulaire.

3. Appareil selon la revendication 2, **caractérisé en ce que** lesdits au moins deux filtres de couleur sont disposés alignés en travers du masque suivant une direction parallèle à la dimension longitudinale d'au moins un ensemble de filtres.

4. Appareil selon l'une quelconque des revendications 2 et 3, **caractérisée en ce que** chaque filtre de couleur présente une même largeur perpendiculairement à la dimension longitudinale du filtre de couleur.

5. Appareil selon la'revendication 4, **caractérisé en ce que** la largeur de chaque filtre de couleur est inférieure à 50 microns.

6. Appareil selon la revendication 5, **caractérisé en ce que** la largeur de chaque filtre de couleur est inférieure à 20 microns.

7. Appareil selon la revendication 6, **caractérisé en ce que** la largeur de chaque filtre de couleur est inférieure à 5 microns.

8. Appareil selon l'une quelconque des revendications 1 à 7, **caractérisé en ce que** lesdits au moins deux filtres de couleur sont espacés d'une distance mutuelle prédéterminée.

9. Appareil selon l'une quelconque des revendications 1 à 8, **caractérisée en ce que** le masque présente entre chaque paire de filtres de couleur au moins une ligne interstitielle de séparation.

10. Appareil selon l'une quelconque des revendications 8 et 9, **caractérisée en ce que** ladite ligne interstitielle de séparation (13) présente une largeur différente moyennant quoi la distance entre les au moins deux filtres de couleur est prédéterminée.

11. Appareil selon l'une quelconque des revendications 1 à 10, **caractérisé en ce que** ledit au moins un ensemble de filtres comporte au moins trois filtres de couleurs dont les longueurs d'onde de transmission sont différentes deux à deux.

12. Appareil selon la revendication 11, **caractérisé en ce qu'**un premier filtre de couleur dudit au moins un premier ensemble de filtres de couleur présente une caractéristique de transmission des longueurs d'ondes correspondant au rouge, un second filtre de couleur dudit au moins un premier ensemble de filtres de couleur présente une caractéristique de transmission des longueurs d'ondes correspondant au vert et un troisième filtre de couleur dudit au moins un premier ensemble de filtres de couleur présente une caractéristique de transmission des longueurs d'ondes correspondant au bleu.

13. Appareil selon l'une quelconque des revendications 1 à 12, **caractérisé en ce que** ledit au moins un ensemble de filtres de couleurs comporte au moins quatre filtres de couleurs dont les longueurs d'ondes de transmission sont différentes deux à deux.

14. Appareil selon l'une quelconque des revendications 1 à 13, **caractérisé en ce que** deux au moins des filtres de couleur dudit au moins un ensemble de filtres de couleurs présentent des caractéristiques de transmission de longueurs d'ondes différentes qui manifestent au moins un recouvrement partiel.

15. Appareil selon l'une quelconque des revendications 1 à 14, **caractérisé en ce qu'**au moins un des filtres de couleur est de forme telle que la lumière sortant dudit au moins un filtre de couleur converge entre ledit au moins un des filtres de couleur et le film noir et blanc.

16. Appareil selon l'une quelconque des revendications 1 à 15, **caractérisé en ce que** l'appareil comporte une diode électroluminescente, Light Emitting Diode (LED pour l'homme de métier) (17) de façon à projeter ladite au moins une marque d'identification sur le film noir et blanc.

17. Appareil selon l'une quelconque des revendications 1 à 16, **caractérisé en ce que** le masque comporte une pluralité d'ensembles de filtres de couleur.

18. Appareil selon la revendication 17 **caractérisées en ce que** lesdits ensembles de filtres de couleur sont identiques.

19. Appareil selon l'une quelconque des revendications 17 et 18, **caractérisé en ce que** lesdits ensembles de filtres de couleur sont séparés par une distance mutuelle prédéterminée.

20. Appareil selon l'une quelconque des revendications 8 et 17 à 19 **caractérisé en ce que** tous les filtres de couleur sont espacés d'une distance mutuelle prédéterminée.

21. Masque selon l'une quelconque des revendications 1 à 20.

22. Méthode d'enregistrement sur un film noir et blanc d'informations relatives à une scène en couleur, dans laquelle on emploie un appareil selon les revendications 1 à 20, dans laquelle la méthode comprend les étapes consistant à :
a) positionner le film noir et blanc dans une chambre de façon à ce que le film occupe une position quasi plane ;
b) faire entrer un flux lumineux coloré par une ouverture de la chambre et le projeter sur le masque ;
c) transmettre le flux lumineux à travers des filtres de couleur ;
d) projeter le lumière transmise par les filtres de couleur sur un film noir et blanc et
e) exposer à la lumière ladite au moins une marque d'identification de façon à projeter ladite marque d'identification sur le film noir et blanc.

23. Appareil pour restituer à partir d'informations en noir et blanc relatives à une scène colorée enregistrées sur un film noir et blanc au moyen d'un appareil selon l'une quelconque des revendications 1 à 20, dans lequel l'appareil de restitution comporte un scanneur pour scanner l'image en noir et blanc sur le film, ou pour scanner une version développée du film, dans lequel le scanner est agencé pour délivrer des mesures en nuances de gris lors du scannage, dans lequel l'appareil comporte en outre un moyen de reconnaissance en cours de scannage de ladite au moins une marque d'identification à la position où elle a été inscrite sur l'image en noir et blanc, dans lequel l'appareil est de plus agencé pour convertir, en fonction de la position de ladite au moins une marque d'identification, les nuances de gris en nuances d'intensités prédéterminées d'une gamme de couleur.

24. Appareil selon la revendication 23, **caractérisé en ce que** l'appareil comporte de plus des moyens de stockage et/ou d'affichage et/ou de traitement des informations de conversion représentatives de la scène en couleur.

25. Appareil selon l'une quelconque des revendications 23 et 24, **caractérisé en ce que** le scanner présente une résolution telle qu'une distance de 50 microns soit enregistrée sur au moins deux pixels.

26. Appareil selon la revendication 25, **caractérisé en ce que** le scanner présente une résolution telle qu'une distance de 20 microns soit enregistrée sur au moins deux pixels.

27. Appareil selon la revendication 26, **caractérisé en ce que** le scanner présente une résolution telle qu'une distance de 5 microns soit enregistrée sur au moins deux pixels.

28. Méthode pour restituer à partir d'une image noir et blanc telle qu'enregistrée sur un film noir et blanc, au moyen d'un appareil selon l'une quelconque des revendications 1 à 20, des informations représentatives d'une scène en couleur, dans laquelle ladite méthode est appliquée en utilisant un appareil selon l'une quelconque des revendications 23 à 27, dans laquelle la méthode comporte les étapes consistant à :
a) scanner l'image on noir et blanc et mesurer, en fonction de la position du scanneur, l'intensité des nuances de gris ;
b) identifier en fonction de la position du scanner ladite au moins une marque d'identification présente sur l'image en noir et blanc ;
c) convertir l'intensité des nuances de gris obtenues en fonction de la position scannée de ladite au moins une marque d'identification, en nuances d'intensités prédéterminées d'une gamme de couleur.

29. Méthode selon les revendications 9 et 28, **caractérisée en ce que**, lors de l'étape a), le scanner vérifie et/ou établit avec plus de précision une position de scannage en fonction de la mesure d'intensité des nuances de gris en utilisant une différence entre l'intensité d'au moins une ligne de couleur uniforme et d'autres intensités des nuances de gris enregistrées sur l'image en noir et blanc, dans laquelle ladite au moins une ligne de couleur uniforme est présente en raison de l'existence de ladite au moins une ligne interstitielle de séparation sur le masque.

30. Méthode selon l'une quelconque des revendications 28 et 29, **caractérisée en ce que** la méthode met aussi en oeuvre des moyens de stockage et/ou d'affichage et/ou de traitement des informations de conversion représentatives de la scène en couleur.

31. Méthode selon l'une quelconque des revendications 28 à 30, **caractérisée on ce que**, lors de l'étape c) l'intensité prédéterminée de la gamme de couleur est ajustée en fonction d'au moins deux gammes de couleur prédéterminées.

32. Méthode selon l'une quelconque des revendications 28 à 31, **caractérisée en ce que** lors de l'étape c) l'intensité retenue dans la gamme de couleur est de plus ajustée en fonction des intensités mesurées des nuances de gris en au moins deux positions de scannage prédéterminées.
